# EUROPEAN PATENT SPECIFICATION

(11) **EP 0 447 236 B1**
(45) Date of publication and mention of the grant of the patent: **10.05.1995**
(21) Application number: 91302166.3
(22) Date of filing: 14.03.1991
(51) Int. Cl.: G11B 7/24, G11B 7/26

(54) **Optical disc**
Optische Platte
Disque optique

(30) Priority: 16.03.1990 JP 64387/90
(43) Date of publication of application: 18.09.1991
(73) Proprietor: SONY CORPORATION, Tokyo (JP)
(72) Inventor: Tatewaki, Masayuki, c/o Sony Corporation, Shinagawa-ku, Tokyo (JP); Kato, Hiromasa, c/o Sony Corporation, Shinagawa-ku, Tokyo (JP); Obinata, Kenichi, c/o Sony Corporation, Shinagawa-ku, Tokyo (JP); Aoki, Masahiro, c/o Sony Corporation, Shinagawa-ku, Tokyo (JP)
(74) Representative: Ayers, Martyn Lewis Stanley

(56) References cited:
- EP-A- 0 316 004
- EP-A- 0 329 122
- EP-A- 0 354 564

## Description

This invention relates to an optical disc, such as a digital audio disc (so-called compact disc) or an optical video disc and to a method of forming the reflective film on such a disc.

An optical disc, such as an digital audio disc or optical video disc, is prepared by forming a reflective film on a transparent substrate, generally formed of polycarbonate or acrylic resin, and forming a hard protective film on the so-formed Aℓ reflective film (EP-A-0329122).

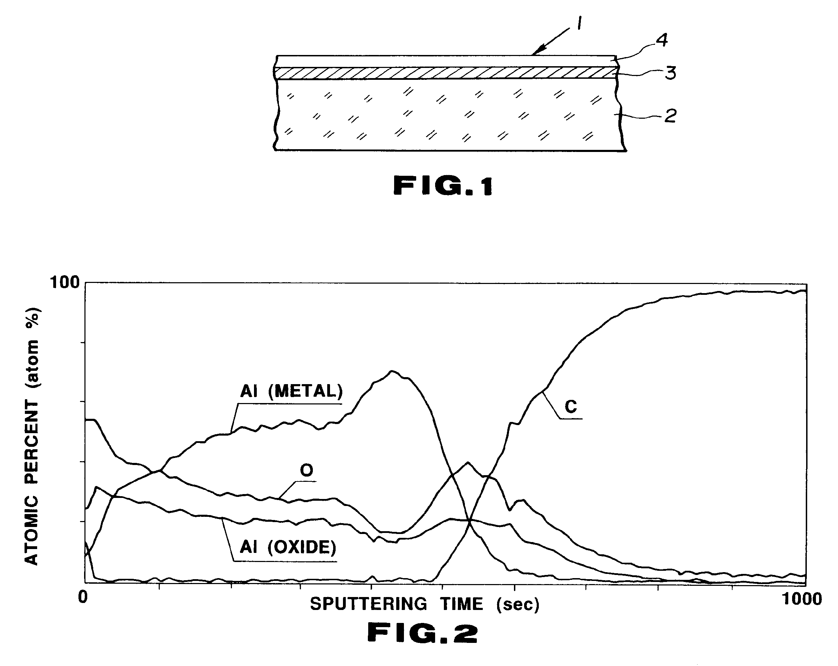

Figure 1 of the accompanying drawings shows the cross-section of such an optical disc. The optical disc 1, shown in figure 1, is constituted by a transparent substrate 2, formed of a synthetic resin, such as polycarbonate or acrylic resin, for reason mainly of mass-producibility, as mentioned above, a reflective film 3 of aluminium or the like, formed on the substrate 2 by sputtering or evaporation, and a protective film 4 formed on the reflective film 3 for protecting the reflective film by spin coating a UV curable resin. In the case of a reproduce-only optical disc, such as a digital audio disc or an optical video disc, a pattern of projections and recesses, corresponding to the recorded signals, are formed on one surface of the transparent substrate 1, more specifically, on the surface thereof opposite to the signal reading surface, that is, on the surface thereof on which the reflective film 3 is formed. In the case of a write-once type optical disc on which information signals can be recorded, or an erasable optical disc, grooves are formed on the same one surface of the transparent substrate 1 as that of the reproduce-only optical disc. Although Au may be used as the material for the reflective film 3, instead of Aℓ, the latter is usually preferred because it is less expensive.

Besides being inexpensive, the Aℓ film is superior in reflectivity and hence is extensively used.

However, the Aℓ reflective film has a deficiency that the film of Aℓ , being metal, is subject to changes with lapse of time on prolonged storage due to extraneous factors, and therefore leaves much to be desired.

For this reason, attempts have been made to form an oxide film on the surface of the Aℓ reflective film by previous oxidation to provide an aluminium-aluminium oxidealuminium three-layer structure to suppress deterioration with lapse of time.

However, this three-layer structure of the Aℓ reflective film is also not fully satisfactory in durability because, if there be any flaw in the Aℓ reflective film, corrosion tends to be started thereat and proceeds into the metal aluminium of the mid-layer of the three-layer structure.

It is therefore a principal object of the present invention to provide an Aℓ reflective film which is less susceptible to changes or deterioration with lapse of time, and an optical disc which, through the use of this Aℓ reflective film, has superior durability.

The present inventors have conducted extensive research towards accomplishing the object and, above all, scrutinised the film structure of the Aℓ reflective film to check for the relationship thereof with durability of the disc. As a result, the present inventors have arrived at a conclusion that an Aℓ reflective film is more invulnerable to changes with lapse of time when it is of such a construction that an oxide is dispersed throughout the Aℓ. reflective film in its entirety.

According to the present invention, there is provided an optical disc comprising a transparent substrate and a reflective film on said substrate, said reflective film being composed mainly of metallic aluminium, characterised in that said reflective film additionally contains an oxide of Aℓ, and in that aluminium and oxygen constituting the oxide of Aℓ bear an oxygen to aluminium atomic ratio of 1.3 or higher.

The invention also provides a method of producing a reflective film essentially composed of aluminium on an optical disc, characterised by comprising introducing, in the course of forming said reflective film on a transparent substrate of said optical disc, a trace amount of oxygen into an atmosphere to which the substrate is exposed.

With the optical disc of the present invention, in which the oxide of Aℓ is dispersed throughout the Aℓ reflective film, the oxidised state of aluminium oxide is critical. Thus the oxide of Aℓ needs to be a stable oxide. It can be checked from the aluminium to oxygen ratio in the oxide of Aℓ whether or not the oxide of Aℓ is stable. The stable oxide of Aℓ herein means an oxide having the oxygen to aluminium atomic ratio of 1.3 or more. Conversely, the oxide is stable if the oxygen to aluminium ratio thereof is less than 1.3.

The state of the oxide of Aℓ influences the durability of the Aℓ reflective film significantly. If the oxide of Aℓ is unstable, with the oxygen to aluminium atomic ratio being less than 1.3, it is difficult to suppress change with lapse of time even if the oxide is dispersed within the Aℓ reflective film.

Thus, in accordance with the present invention, the oxide of Aℓ is a stable oxide, with the oxygen to aluminium atomic ratio of the oxide of Aℓ being 1.3 or higher for assuring the durability of the Aℓ reflective film. Although there is no upper limit to the oxygen to aluminium atomic ratio, if it is not less than 1.3, there is a limit imposed by the chemical composition of the oxide, such that the ratio Aℓ:0 is preferably 1:1.3 to 1:2.0.

With the Aℓ reflective film of the optical disc of the present invention, pure Aℓ not bound with oxygen coexists with the oxide of Aℓ that is, Aℓ bound with oxygen. Pure Aℓ is necessitated to assure the reflectivity of the reflective film, while the oxide of Aℓ is necessitated to suppress changes thereof with lapse of time. This needs to be considered in determining the amount of the oxide of Aℓ in the Aℓ reflective film. It is practically desirable that the reflectivity of the Aℓ reflective film is 70 percent or higher, and that the amount of the oxide of Aℓ be such that changes with lapse of time of the Aℓ reflective film may be suppressed to as low a value as possible, as the most preferred amounts of the oxide of Aℓ , pure Aℓ and Aℓ bound with oxygen are contained in the Aℓ reflective film in relative amounts such that the amount of Aℓ bound with oxygen accounts for substantially 26 to 33 atomic percent.

The above mentioned oxide of Aℓ is produced by introducing a minor amount of oxygen into the atmosphere around the substrate during formation of the Aℓ reflective film by evaporation or sputtering. The amount of oxygen introduced into atmosphere may be determined, as a function of the rate of film formation or the like, so that the produced Aℓ reflective film will satisfy the above mentioned requirements.

The Aℓ reflective layer may be of an Aℓ monolayer structure into which the oxide of Aℓ is dispersed as described above, or may be so constructed that a thin oxide film is formed on the film surface and a larger amount of the oxide of Aℓ exists near the film surface.

The present invention may be applied to any optical disc provided with the Aℓ reflective film. Thus it may be applied not only to a digital audio disc or a video disc, but to a once-write type disc, such as a magneto-optical disc, or an overwrite type disc, provided that the disc is provided with the Aℓ reflective film.

There is also no limitation to the substrate material and any well-known type material, including a transparent resin, such as acrylic resin or polycarbonate, may be employed.

With the oxide of Aℓ in the stable state coexisting in the Aℓ reflective film, it becomes possible to suppress changes with lapse of time and to improve the durability of the optical disc.

The reflectivity of the Aℓ reflective film may be assured by the presence of pure Aℓ (metallic Aℓ) not bound with oxygen.

The invention will be further described by way of non-limitative example with reference to the accompanying drawings, in which:-

Figure 1 is a cross-sectional view showing the general construction of an optical disc.

Figures 2 and 3 are diagrams showing a density profile along the film thickness of an Aℓ reflective film produced by evaporation under introduction of oxygen, figure 2 showing the density profile before the accelerated deterioration test and figure 3, the density profile after the accelerated deterioration test.

The present invention will be hereinafter explained on the basis of concrete test results.

First, Aℓ was evaporated on a polymethyl methacrylate (PMMA) substrate, under introduction of oxygen, for forming an Aℓ reflective film. The film thickness of the produced Aℓ reflective film was of the order of 70 to 80 nm.

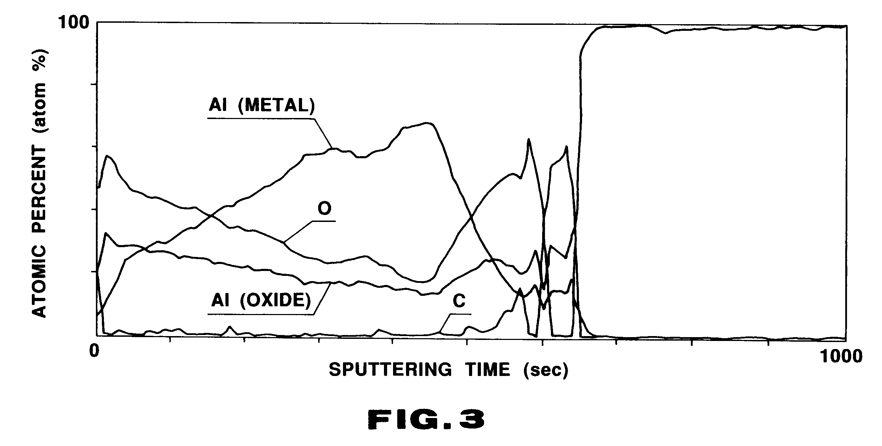

The produced Aℓ reflective film was analysed by an X-ray photoelectron spectrometry (XPS). The results are shown in figure 2.

With XPS, the kinetic energy of photoelectrons emitted from atoms upon irradiation of X-rays is sequentially measured to obtain an information concerning the constituent elements, the quantities and the state of bonding thereof. Thus the pure Aℓ (metal Aℓ) not bound with oxygen and Aℓ bound with oxygen and thus existing as oxide may be quantitatively determined in isolation from each other. It is noted that argon ion sputtering was performed simultaneously for analysing the Aℓ reflective film along its depth.

Figure 2 shows the density profile of Aℓ not bound with oxygen, referred to hereinafter as metal Aℓ, Aℓ bound with oxygen, referred to hereinafter as the oxide Aℓ, oxygen and carbon, as measured along the thickness of the Aℓ reflective film. In the drawing, the abscissa stands for the film thickness in terms of the sputtering time and the ordinate stands for the amounts of the respective elements in terms of atomic percent.

It is seen from figure 2 that the oxide of Aℓ is contained in the Aℓ reflective film evaporated under introduction of oxygen in an amount in the order of 30 atomic percent as Aℓ. The 0 to Aℓ atomic ratio O/Aℓ in the oxide of Aℓ is 1.3 or higher.

The optical disc, on which the Aℓ reflective film has been formed in this manner, was subject to an accelerated deterioration test to check for possible occurrence of changes with lapse of time. The conditions for the accelerated deterioration tests were a temperature of 60°C, a relative humidity of 85 percent and a test duration of 200 hours.

As a result, changes in the Aℓ reflective film with lapse of time were scarcely observed even after the accelerated deterioration tests.

Figure 3 shows the profile of the Aℓ reflective film after the accelerated deterioration tests. It is seen from this figure that no changes are observed in the profile of the Aℓ reflective film after the accelerated deterioration tests.

For comparison, similar tests were conducted on an optical disc on which the Aℓ reflective film has been formed without introducing oxygen. A small amount of the oxide of Aℓ was contained in the Aℓ reflective film formed without introducing oxygen, the atomic ratio of 0 to Aℓ O/Aℓ in the oxide of Aℓ being about equal to 1. Although substantially no changes were observed between the density profile before the accelerated deterioration test and that after the accelerated deterioration test, the Aℓ reflective film after the accelerated deterioration test obviously underwent changes with lapse of time.

From the foregoing it is seen that the present invention provides an optical disc in which a stable oxide of Aℓ co-exists in the Aℓ reflective film to suppress changes of the Aℓ reflective film with lapse of time to improve the durability of the optical disc.

In addition, the desired reflectivity of the Aℓ reflective film may be assured by aluminium not combined with oxygen to improve the reflectivity of the optical disc.

## Claims

1. An optical disc (1) comprising a transparent substrate (2) and a reflective film (3) on said substrate (2), said reflective film (3) being composed mainly of metallic aluminium, characterised in that said reflective film additionally contains an oxide of Aℓ, and in that aluminium and oxygen constituting the oxide of Aℓ bear an oxygen to aluminium atomic ratio of 1.3 or higher.

2. An optical disc (1) according to claim 1 wherein aluminium and oxygen constituting the oxide of Aℓ bear an oxygen to aluminium atomic ratio in the range of from 1.3 to 2.0.

3. An optical disc (1) according to claim 1 or 2 wherein, in terms of the atomic ratio of aluminium not bound with oxygen and aluminium bound with oxygen in said reflective film (3), the proportion of aluminium bound with oxygen amounts approximately to 26 to 33 atomic percent.

4. A method of producing a reflective film (3) essentially composed of aluminium on an optical disc (1), characterised by introducing, in the course of forming said reflective film (3) on a transparent substrate (2) of said optical disc (1), a trace amount of oxygen into an atmosphere to which the substrate is exposed.

5. The method according to claim 4 wherein the amount of oxygen introduced into atmosphere is such that the oxide of Aℓ contained in the formed reflective film (3) with aluminium and oxygen constituting said oxide of Aℓ bearing an oxygen to aluminium atomic ratio of 1.3 or higher.

## Patentansprüche

1. Optische Platte (1) mit einem transparenten Substrat (2) und einer reflektierenden Schicht (3) auf dem Substrat (2), wobei die reflektierende Schicht (3) hauptsächlich aus metallischem Aluminium besteht, dadurch gekennzeichnet, daß die reflektierende Schicht zusätzlich ein Aluminiumoxyd enthält, und daß Aluminium und Sauerstoff, welche das Aluminiumoxyd bilden, ein Atomverhältnis von Sauerstoff zu Aluminium von 1,3 oder höher besitzen.

2. Optische Platte (1) nach Anspruch 1, bei welcher Aluminium und Sauerstoff, welche das Aluminiumoxyd bilden ein Atomverhältnis von Sauerstoff zu Aluminium im Bereich von 1,3 bis 2,0 besitzen.

3. Optische Platte (1) nach Anspruch 1 oder 2, bei welcher hinsichtlich des Atomverhältnisses von nicht mit Sauerstoff gebundenem Aluminium und mit Sauerstoff gebundenem Aluminium in der reflektierenden Schicht der Anteil von mit Sauerstoff gebundenem Aluminium annähernd 26 bis 33 Prozent beträgt.

4. Verfahren zur Herstellung einer im wesentlichen aus Aluminium bestehenden reflektierenden Schicht (3) auf einer optischen Platte (1), gekennzeichnet durch das Einbringen eines Spurengehalts von Sauerstoff in eine Atmosphäre, welcher das Substrat ausgesetzt ist, während der Ausbildung der reflektierenden Schicht (3) auf einem transparenten Substrat (2) der optischen Platte (1).

5. Verfahren nach Anspruch 4, bei welchem der Betrag des in die Atmosphäre eingebrachten Sauerstoffs derart ist, daß das in der ausgebildeten reflektierenden Schicht (3) enthaltene Aluminiumoxyd, wobei Aluminium und Sauerstoff das Aluminiumoxyd bilden, ein Atomverhältnis von Sauerstoff zu Aluminium von 1,3 oder höher besitzt.

## Revendications

1. Disque optique (1) comprenant un substrat transparent (2) et une couche réfléchissante (3) sur ledit substrat (2), ladite couche réfléchissante (3) étant constituée principalement par de l'aluminium métallique, caractérisé en ce que ladite couche réfléchissante contient en outre un oxyde de Aℓ et en ce que l'aluminium et l'oxygène constituant l'oxyde de Aℓ présentent un rapport atomique de l'oxygène à l'aluminium de 1,3 ou plus.

2. Disque optique (1) selon la revendication 1, dans lequel l'aluminium et l'oxygène constituant l'oxyde de Aℓ présentent un rapport atomique de l'oxygène à l'aluminium situé dans le domaine de 1,3 à 2,0.

3. Disque optique (1) selon la revendication 1 ou 2, dans lequel, en termes du rapport atomique de l'aluminium non lié à l'oxygène et de l'aluminium lié à l'oxygène dans ladite couche réfléchissante (3), la proportion d'aluminium lié à l'oxygène s'élève approximativement à 26 à 33 % atomique.

4. Procédé de production d'une couche réfléchissante (3) composée essentiellement d'aluminium sur un disque optique (1), caractérisé par l'introduction, au cours de la formation de ladite couche réfléchissante (3) sur un substrat transparent (2) dudit disque optique (1), d'une quantité à l'état de trace d'oxygène dans une atmosphère à laquelle est exposé le substrat.

5. Procédé selon la revendication 4, dans lequel la quantité d'oxygène introduite dans l'atmosphère est telle que, dans l'oxyde de Aℓ contenu dans la couche réfléchissante (3) formée, l'aluminium et l'oxygène constituant ledit oxyde de Aℓ présentent un rapport atomique de l'oxygène à l'aluminium de 1,3 ou plus.
